# FASCICULE DE BREVET EUROPEEN

(11) **EP 3 365 924 B1**
(45) Date de publication et mention de la délivrance du brevet: **19.05.2021**
(21) Numéro de dépôt: 16785124.5
(22) Date de dépôt: 20.10.2016
(51) Int. Cl.: H01L 33/38, H01L 33/00, H01L 25/075, H01L 27/15

(54) **DIODE MICRO-ELECTRONIQUE A SURFACE ACTIVE OPTIMISEE**
MIKROELEKTRONISCHE DIODE MIT OPTIMIERTER AKTIVER OBERFLÄCHE
MICROELECTRONIC DIODE WITH OPTIMISED ACTIVE SURFACE

(30) Priorité: 22.10.2015 FR 1560077
(43) Date de publication de la demande: 29.08.2018
(73) Titulaire: Commissariat à l'Energie Atomique et aux Energies Alternatives, 75015 Paris (FR)
(72) Inventeur: BONO, Hubert, 38000 Grenoble (FR); GARCIA, Jonathan, 38930 Monestier du Percy (FR); ROBIN, Ivan-Christophe, 38000 Grenoble (FR)
(74) Mandataire: Brevalex
(86) Numéro de dépôt international: PCT/EP2016/075199
(87) Numéro de publication internationale: WO 2017/068029

(56) Documents cités:
- EP-A1- 2 865 021
- EP-A2- 2 408 029
- WO-A1-2014/105403
- KR-A- 20090 011 372
- US-A1- 2006 214 173
- US-A1- 2009 184 337
- US-A1- 2015 108 514

## Description

### DOMAINE TECHNIQUE ET ART ANTÉRIEUR

L'invention concerne le domaine des diodes photo-émettrices telles que des diodes électroluminescentes (appelées DELs ou LEDs, ou encore micro-LEDs) ainsi que celui des diodes photo-réceptrices telles que des photodiodes. L'invention s'applique notamment au domaine des dispositifs d'éclairage par LEDs, des dispositifs électroniques émissifs lumineux comprenant des matrices de LEDs tels que des écrans, des projecteurs ou des murs d'images, ainsi qu'au domaine des dispositifs électroniques ou microélectroniques photorécepteurs comportant des matrices de photodiodes, tels que des capteurs d'images.

La réalisation de diodes, par exemple lors de la réalisation d'une matrice de photodiodes ou de LEDs formant une matrice de pixels, se base généralement sur des procédés microélectroniques standards utilisés communément en technologie dite planaire et au cours desquels chaque élément des diodes est réalisé par une première étape de dépôt, puis une étape de lithographie suivie d'une étape de gravure. Avec ce type de procédé, la réalisation de chaque motif d'un matériau des diodes nécessite la mise en œuvre d'au moins trois étapes distinctes. De plus, chaque motif réalisé doit être aligné avec ceux déjà présents. Enfin, la définition de chaque motif doit prendre en compte les performances des équipements concernés tant en termes de dimensions atteignables que de performances d'alignement par rapport au motif précédent.

De plus, pour obtenir des performances suffisantes avec les technologies standards de la micro-électronique, il est nécessaire de réaliser une planarisation des éléments réalisés afin de maîtriser les étapes de lithographie mises en œuvre sur ces éléments car la résolution atteignable avec une telle étape de lithographie est directement liée à la topographie sur laquelle la lithographie est mise en œuvre, les objectifs optiques à très grandes ouvertures utilisés dans les dispositifs d'insolation lithographiques ayant des profondeurs de champ qui s'amenuisent avec l'augmentation de la résolution.

Dans une matrice de diodes standards, des étapes de dépôt, lithographie et gravure sont successivement mises en œuvre pour réaliser les contacts électriques (anodes et cathodes) des diodes ainsi que les couches d'isolation électrique entre ces contacts électriques. Or, il est indispensable de maîtriser l'isolation électrique entre la cathode et l'anode de chacune des diodes. La réalisation de l'isolation électrique entre les électrodes des diodes via la réalisation de couches d'isolation déposées conformément aux motifs de la structure engendre une perte importante de surface active disponible (correspondant à la surface occupée par les éléments de diodes réalisant la conversion photoélectrique ou l'émission lumineuse, à savoir la jonction p-n de la diode) par rapport à la surface totale disponible sur laquelle la matrice de diodes est réalisée, étant donné la surface occupée par ces couches d'isolation électrique.

Dans le document FR 2 992 465 A, un dispositif à LEDs est réalisé à partir d'un empilement de couches semi-conductrices pré-structurées sous formes d'îlots indépendants, chaque îlot servant à la réalisation d'une LED du dispositif. La surface occupée par chacune des LED est donc prédéfinie et les étapes de dépôt, de lithographie et de gravure mises en œuvre ne permettent pas de minimiser la perte de surface active engendrée par l'utilisation d'îlots dont les dimensions, dans le plan du substrat, ne correspondent pas à celles des jonctions p-n à réaliser. La réalisation de l'anode de chaque LED comporte la gravure d'une ouverture d'une couche diélectrique déposée au préalable sur le semi-conducteur de type p. Pour assurer une bonne définition géométrique de cette électrode, il est nécessaire de réaliser cette ouverture par une gravure sèche assistée par plasma. Or, l'InGaN utilisé pour la réalisation de ce dispositif est un semi-conducteur à grand gap qui est altérer par ce type de gravure, ce qui conduit à une mauvaise interface électrique et donc à une dégradation irréversible des propriétés électriques des LEDs. En outre, dans ce type de LED, le contact électrique entre la cathode et le semi-conducteur de type n est obtenu principalement par la surface de contact horizontale obtenue en gravant l'îlot de semi-conducteur, ce qui représente une perte supplémentaire de surface active. En outre, de nombreuses étapes de lithographie doivent être mises en œuvre pour achever le dispositif. Enfin, les portions de semi-conducteur de type n formant les surfaces de contact électrique horizontales sur lesquelles sont disposées les cathodes engendrent des pertes lumineuses sur les côtés des LEDs car une partie de la lumière est guidée horizontalement par ces portions de semi-conducteur et se perd dans l'environnement autour de la LED. Les LEDs de ce dispositif sont mal isolées optiquement les unes des autres, ce qui nuit à la résolution de l'image obtenue avec ce dispositif
Les documents US 2009/184337 A1, US 2006/214173 A1, WO 2014/105403 A1 et US 2015/108514 A1 divulguent des dispositifs optoélectroniques avec des électrodes sur les flancs latéraux de la structure semi-conductrice.

### EXPOSÉ DE L'INVENTION

Un but de la présente invention est de proposer une diode dont la structure permet de minimiser les pertes de surface active ainsi que les pertes optiques latérales, toute en réduisant le nombre d'étapes à mettre en œuvre pour sa réalisation afin de réduire son coût de réalisation
Pour cela, l'invention est définie en revendication indépendante 1 de produit et la revendication indépendante de procédé 12.

Il est proposé une diode comportant au moins :
- un substrat;
- une première et une deuxième portions de semi-conducteur dopées formant une jonction p-n, la première portion de semi-conducteur étant disposée entre le substrat et la deuxième portion de semi-conducteur ;
- des portions diélectriques recouvrant des flancs latéraux de la deuxième portion de semi-conducteur et d'une première partie de la première portion de semi-conducteur ;
- une première électrode reposant sur le substrat et disposée contre les portions diélectriques et des flancs latéraux d'une deuxième partie de la première portion de semi-conducteur qui est disposée entre la première partie de la première portion de semi-conducteur et le substrat, la première électrode étant reliée électriquement à la première portion de semi-conducteur uniquement par un contact avec les flancs latéraux de la deuxième partie de la première portion de semi-conducteur;
- une deuxième électrode reliée électriquement à la deuxième portion de semi-conducteur telle que la deuxième portion de semi-conducteur soit disposée entre la deuxième électrode et la première portion de semi-conducteur.

L'invention propose en outre une diode photo-émettrice ou photo-réceptrice, comportant au moins :
- une première et une deuxième portions de semi-conducteur dopées formant une jonction p-n, une première partie de la première portion de semi-conducteur étant disposée entre une deuxième partie de la première portion de semi-conducteur et la deuxième portion de semi-conducteur ;
- des portions diélectriques recouvrant des flancs latéraux de la deuxième portion de semi-conducteur et de la première partie de la première portion de semi-conducteur ;
- une première électrode disposée contre des flancs latéraux extérieurs des portions diélectriques et contre des flancs latéraux de la deuxième partie de la première portion de semi-conducteur, reliée électriquement à la première portion de semi-conducteur uniquement par un contact avec les flancs latéraux de la deuxième partie de la première portion de semi-conducteur, et traversant toute l'épaisseur de la première portion de semi-conducteur;
- une deuxième électrode optiquement réflectrice et reliée électriquement à la deuxième portion de semi-conducteur telle que la deuxième portion de semi-conducteur soit disposée entre la deuxième électrode et la première portion de semi-conducteur ;
et dans laquelle une lumière est destinée à être émise ou reçue par la diode à travers la première portion de semi-conducteur.

Dans cette diode, la première électrode est reliée électriquement à la première portion de semi-conducteur uniquement au niveau des flancs latéraux de la deuxième partie de cette portion. Ainsi, contrairement aux diodes de l'art antérieur dans lesquelles une surface horizontale de contact, c'est-à-dire une surface de contact sensiblement parallèle au plan principal du substrat, est réalisée en gravant le semi-conducteur, le fait de n'utiliser que les flancs latéraux pour réaliser ce contact électrique permet d'optimiser au mieux la surface occupée par la diode et maximiser sa surface active. De plus, cette absence de surface de contact horizontale avec la première portion de semi-conducteur permet d'éviter les pertes optiques engendrées par une structure comportant de telles surfaces de contact (du fait que les différences de dimensions, dans le plan parallèle au substrat, entre les différentes parties de la première portion de semi-conducteur sont minimes), ce qui améliore l'isolation optique de la diode ainsi que son rendement d'émission ou de conversion de la lumière.

Cette diode fait appel à des portions diélectriques, ou portions d'isolation électrique, recouvrant les flancs latéraux d'une partie des éléments formant la jonction p-n de la diode et permettant d'isoler électriquement et de passiver ces flancs latéraux, notamment vis-à-vis de la première électrode, et également d'isoler électriquement les portions de semi-conducteur dopées de la jonction p-n l'une vis-à-vis de l'autre lorsque celles-ci ne sont pas en contact direct l'une contre l'autre (notamment lorsqu'une ou plusieurs couches émissives sont présentes entre les première et deuxième portions de semi-conducteur, ou bien qu'une portion de semi-conducteur intrinsèque est disposée entre elles). Ces portions diélectriques permettent également d'assurer l'isolation électrique entre la première et la deuxième électrodes en occupant un minimum de place dans la diode. Cette localisation des portions diélectriques sur les flancs latéraux de la jonction p-n de la diode ainsi que la réalisation du contact électrique entre la première portion de semi-conducteur et la première électrode uniquement par les flancs latéraux d'une partie de la première portion de semi-conducteur permet d'améliorer le rapport entre la surface active de la diode (surface occupée par la jonction p-n) occupée sur le substrat et la surface totale du substrat sur laquelle la diode est réalisée, et donc d'augmenter l'intégration de la diode sur le substrat étant donné le faible encombrement des portions diélectriques et de la première électrode qui ont chacun une structure verticale (parallèle aux flancs latéraux de la jonction p-n de la diode qui sont recouverts par ces portions diélectriques et par la première électrode). Cette forte intégration permet par exemple la réalisation de dispositif électronique d'affichage dont les pixels ont pour dimension latérale de l'ordre de 7 µm et sont espacés d'une distance d'environ 3 µm.

De plus, cette forte intégration des portions diélectriques a également pour avantage de minimiser les densités de courant obtenues dans les électrodes de la diode, et donc de réduire l'échauffement par effet Joule engendré dans la diode via une baisse globale de la résistance thermique de la diode.

La structure de cette diode permet de réduire son coût de fabrication ainsi que sa consommation d'énergie. Dans le domaine de l'éclairage, une telle diode permet d'améliorer l'injection électrique en son sein et donc d'augmenter son rendement énergétique. Dans le domaine des dispositifs imageurs, une telle diode permet de réaliser des dispositifs à haute résolution par la réduction de la taille des pixels qui devient limitée uniquement par les moyens de mise en forme utilisés.

La jonction p-n formée par les première et deuxième portions de semi-conducteur et les portions diélectriques recouvrant les flancs latéraux de la deuxième portion de semi-conducteur et de la première partie de la première portion de semi-conducteur peuvent former une structure mesa. L'expression « structure mesa » désigne le fait que la diode est réalisée sous la forme d'un empilement de la première et de la deuxième portions de semi-conducteur dopées, une zone de jonction étant présente entre ces deux portions de semi-conducteur dopées, et que cet empilement est ici gravé sur toute sa hauteur sous forme d'un îlot appelé mesa. En outre, cet îlot comporte, au niveau des flancs latéraux de la deuxième partie de la première portion de semi-conducteur dopée, une zone de contact électrique de la première portion de semi-conducteur dopée à laquelle est reliée la première électrode.

En outre, du fait que le contact électrique entre la première électrode et la première portion de semi-conducteur est réalisé sur les flancs latéraux de la deuxième partie de la première portion de semi-conducteur, la résistance de contact, qui est inversement proportionnelle à la surface de contact, est totalement indépendante de la largeur des espaces séparant les diodes et dans lesquelles les premières électrodes sont disposées.

Dans cette diode, la deuxième électrode qui est disposée du côté de la diode qui est opposé à celui par lequel la lumière est destinée à entrer ou sortir de la diode, est optiquement réflectrice. Ainsi, la lumière entre ou sort de la diode sans avoir à traverser une électrode transparente, par exemple à base d'ITO, qui engendre des pertes optiques de la lumière émise ou reçue.

De plus, du fait que la première électrode traverse toute l'épaisseur de la première portion de semi-conducteur, la diode est bien isolée des éventuelles autres diodes voisines, ce qui permet d'éviter les interactions lumineuses entre les diodes voisines.

Enfin, les portions diélectriques présentes contre les flancs latéraux de la deuxième portion de semi-conducteur et de la première partie de la première portion de semi-conducteur réalisent une passivation de ces flancs latéraux.

La première portion de semi-conducteur peut être dopée n et la deuxième portion de semi-conducteur peut être dopée p, la première électrode pouvant former une cathode de la diode et la deuxième électrode pouvant former une anode de la diode.

La diode peut comporter en outre un masque diélectrique tel qu'une première partie de la deuxième électrode soit disposée entre le masque diélectrique et la deuxième portion de semi-conducteur, qu'au moins une deuxième partie de la deuxième électrode puisse être disposée dans au moins une ouverture traversant le masque diélectrique, et que les portions diélectriques puissent recouvrir des flancs latéraux du masque diélectrique.

Dans ce cas, des faces supérieures du masque diélectrique, des portions diélectriques et des première et deuxième électrodes peuvent former ensemble une surface continue sensiblement plane de la diode. Cette surface continue sensiblement plane permet d'hybrider facilement, par exemple sans faire appel à des inserts tels que des microbilles de connexion, la diode à un autre élément tel qu'un substrat permettant de réaliser différentes configurations de connexion de la diode et pouvant comporter également une face plane au niveau de laquelle se trouvent des matériaux analogues à ceux de la diode, par exemple par collage direct métal contre métal (pour les électrodes) et diélectrique contre diélectrique (pour les portions diélectriques et le masque diélectrique). Cette surface continue sensiblement plane est également bien adaptée pour la réalisation d'une structure d'interconnexions directement sur les électrodes, évitant ainsi bon nombre de difficultés liées à la topologie résiduelle des structures des diodes de l'art antérieur.

Les faces supérieures du masque diélectrique, des première et deuxième électrodes et des portions diélectriques forment une surface continue sensiblement plane, c'est-à-dire sont disposées sensiblement dans un même plan. L'expression « sensiblement plane » est ici utilisée pour désigner le fait que la surface formée par les faces supérieures du masque diélectrique, des électrodes et des portions diélectriques peut présenter des variations de hauteur, ou d'épaisseur, comprises entre environ 0 et 150 nm. Ces légères variations de hauteur ou d'épaisseur peuvent avoir pour origine la mise en œuvre d'une planarisation mécano-chimique (CMP) mise en œuvre en présence des matériaux des électrodes, du masque diélectrique et des portions diélectriques, les vitesses de gravure de ces différents matériaux étant différentes les unes des autres. Ces légères variations de hauteur ou d'épaisseur, entre les faces supérieures des portions diélectriques, du masque diélectrique et celles des électrodes, peuvent avoir pour avantage de garantir une excellente isolation entre les électrodes de la diode et/ou vis-à-vis d'électrodes de diodes adjacentes lorsque des creux sont formés au niveau des faces supérieures des électrodes.

Des flancs latéraux extérieurs des portions diélectriques peuvent être alignés avec les flancs latéraux de la deuxième partie de la première portion de semi-conducteur. Cette configuration facilite la réalisation de la première électrode et optimise en outre l'encombrement de la structure formée par les portions de semi-conducteur et les portions diélectriques.

La première portion de semi-conducteur peut comporter un empilement d'au moins deux semi-conducteurs dopés selon des niveaux de conductivité différents. Par exemple, lorsque la première portion de semi-conducteur est dopée n, elle peut comporter un empilement d'un premier semi-conducteur dopé n+ disposé sur le substrat et d'un deuxième semi-conducteur dopé n- disposé sur le premier semi-conducteur.

L'épaisseur de la première portion de semi-conducteur est avantageusement comprise entre environ 2 µm et 4 µm. Une telle épaisseur peut être obtenue du fait que la première portion de semi-conducteur est disposée directement sur le substrat, sans la présence d'une couche diélectrique entre la première portion de semi-conducteur et le substrat. Cette épaisseur permet d'avoir un très bon contact électrique entre la première portion de semi-conducteur et la première électrode uniquement par les flancs latéraux de la première portion de semi-conducteur, sans avoir à réaliser une surface de contact horizontale (parallèle au plan principal du substrat) pour former la liaison électrique entre la première électrode et la première portion de semi-conducteur. Une telle épaisseur de la première portion de semi-conducteur permet également la mise en œuvre d'un retrait par laser (« laser lift-off ») du substrat, bien qu'aucune couche diélectrique soit interposée entre le substrat et la première portion de semi-conducteur, un tel retrait pouvant être mis en œuvre après une hybridation des électrodes de la diode sur un substrat d'interconnexions.

La diode peut être une photodiode ou une LED.

Dans ce cas, la photodiode peut comporter au moins une portion de semi-conducteur intrinsèque disposée entre les première et deuxième portions de semi-conducteur et telle que des flancs latéraux de la portion de semi-conducteur intrinsèque soient recouverts par les portions diélectriques, ou la LED peut comporter au moins une zone active émissive à au moins un puits quantique disposée entre les première et deuxième portions de semi-conducteur et telle que des flancs latéraux de la zone active émissive soient recouverts par les portions diélectriques.

La diode peut comporter en outre un substrat d'interconnexions sur lequel la diode est disposée et auquel les première et deuxième électrodes de la diode sont reliées électriquement. Ce substrat d'interconnexions peut donc être disposé au niveau de la face arrière de la diode, c'est-à-dire la face au niveau de laquelle se trouvent les deux électrodes de la diode.

L'invention porte également sur un dispositif électronique comportant plusieurs diodes telles que décrites précédemment, dans lequel chacune des premières électrodes est en outre reliée électriquement à la première portion de semi-conducteur d'au moins une diode voisine uniquement par un contact avec les flancs latéraux de la deuxième partie de la première portion de semi-conducteur de ladite au moins une diode voisine. L'intégration des diodes est ainsi maximisée au sein du dispositif électronique du fait que les premières électrodes peuvent remplir des espaces entre deux diodes voisines.

Les premières électrodes des diodes du dispositif peuvent former une cathode commune à ces diodes.

Les diodes peuvent faire partie d'une matrice de diodes de structures similaires formant une matrice de pixels du dispositif électronique.

Il est également décrit un procédé de réalisation d'une diode, comportant au moins les étapes de :
- réalisation, sur un substrat, d'un empilement de couches comprenant au moins des première et deuxième couches de semi-conducteur dopées selon des types de conductivité opposés, telles que la première couche de semi-conducteur soit disposée entre la deuxième couche de semi-conducteur et le substrat, et comprenant au moins une couche électriquement conductrice disposée sur la deuxième couche de semi-conducteur ;
- première gravure de l'empilement de couches à travers la couche électriquement conductrice, la deuxième couche de semi-conducteur et une partie de l'épaisseur de la première couche de semi-conducteur, formant une première partie de la deuxième électrode, une deuxième portion de semi-conducteur et une première partie d'une première portion de semi-conducteur;
- réalisation de portions diélectriques recouvrant des flancs latéraux de la première partie de la deuxième électrode, de la deuxième portion de semi-conducteur et de la première partie de la première portion de semi-conducteur;
- deuxième gravure de l'empilement de couches à travers une épaisseur restante de la première couche de semi-conducteur jusqu'à atteindre le substrat, formant une deuxième partie de la première portion de semi-conducteur disposée entre la première partie de la première portion de semi-conducteur et le substrat, les première et deuxième portions de semi-conducteur formant une jonction p-n ;
- réalisation d'une première électrode reposant sur le substrat et disposée contre les portions diélectriques et des flancs latéraux de la deuxième partie de la première portion de semi-conducteur, la première électrode étant reliée électriquement à la première portion de semi-conducteur uniquement par un contact avec les flancs latéraux de la deuxième partie de la première portion de semi-conducteur, et réalisation d'une deuxième partie de la deuxième électrode sur la première partie de la deuxième électrode.

L'invention propose en outre un procédé de réalisation d'une diode photo-émettrice ou photo-réceptrice, comportant au moins les étapes de :
- réalisation d'un empilement de couches comprenant au moins des première et deuxième couches de semi-conducteur dopées selon des types de conductivité opposés et au moins une couche électriquement conductrice et optiquement réflectrice, telles que la deuxième couche de semi-conducteur soit disposée entre la première couche de semi-conducteur et la couche électriquement conductrice et optiquement réflectrice ;
- première gravure de l'empilement de couches à travers la couche électriquement conductrice, la deuxième couche de semi-conducteur et une partie de l'épaisseur de la première couche de semi-conducteur, formant une première partie d'une deuxième électrode de la diode, une deuxième portion de semi-conducteur et une première partie d'une première portion de semi-conducteur à travers laquelle une lumière est destinée à être émise ou reçue par la diode ;
- réalisation de portions diélectriques recouvrant des flancs latéraux de la première partie de la deuxième électrode, de la deuxième portion de semi-conducteur et de la première partie de la première portion de semi-conducteur ;
- deuxième gravure de l'empilement de couches à travers une épaisseur restante de la première couche de semi-conducteur, formant une deuxième partie de la première portion de semi-conducteur telle que la première partie de la première portion de semi-conducteur soit disposée entre la deuxième partie de la première portion de semi-conducteur et la première partie de la deuxième électrode, les première et deuxième portions de semi-conducteur formant une jonction p-n ;
- réalisation d'une première électrode disposée contre des flancs latéraux extérieurs des portions diélectriques et contre des flancs latéraux de la deuxième partie de la première portion de semi-conducteur, la première électrode étant reliée électriquement à la première portion de semi-conducteur uniquement par un contact avec les flancs latéraux de la deuxième partie de la première portion de semi-conducteur et traversant toute l'épaisseur de la première portion de semi-conducteur, et réalisation d'une deuxième partie de la deuxième électrode sur la première partie de la deuxième électrode.

Les portions diélectriques étant déposées sur les flancs latéraux de la structure gravée dans l'empilement de couches, ces portions diélectriques peuvent être réalisées par un procédé auto-aligné permettant d'isoler les électrodes de la diode sans faire appel à un masque spécialement adapté à la réalisation de ces portions diélectriques, par exemple via un dépôt conforme du matériau des portions diélectriques puis un gravure des portions de ce matériau qui ne recouvrent pas les flancs latéraux des structures.

La première gravure de l'empilement de couches peut être mise en œuvre à travers un masque diélectrique disposé sur l'empilement de couches, et les portions diélectriques peuvent recouvrir des flancs latéraux du masque diélectrique.

La deuxième gravure de l'empilement peut être réalisée telle que des flancs latéraux extérieurs des portions diélectriques soient alignés avec les flancs latéraux de la deuxième partie de la première portion de semi-conducteur.

La réalisation de la première électrode et de la deuxième partie de la deuxième électrode peut comporter la mise en œuvre des étapes suivantes :
- réalisation d'une ouverture à travers le masque diélectrique et débouchant sur la première partie de la deuxième électrode ;
- dépôt d'au moins un matériau électriquement conducteur dans l'ouverture et dans un espace formé à travers l'empilement de couches par la mise en œuvre des première et deuxième gravures ;
- planarisation du matériau électriquement conducteur avec arrêt sur le masque diélectrique.

La réalisation des électrodes correspond dans ce cas à la mise en œuvre d'un procédé de type « damascène » dans lequel un ou plusieurs matériaux électriquement conducteurs sont formés par au moins un dépôt pleine plaque, c'est-à-dire un dépôt du matériau électriquement conducteur sur l'ensemble de la structure réalisée, les électrodes étant obtenues ensuite via une planarisation de ce matériau électriquement conducteur. La réalisation de la première électrode ne nécessite donc pas une étape d'alignement spécifique ou de masquage particulier. L'emplacement de la première électrode peut correspondre à un espace formé entre les portions diélectriques recouvrant les flancs latéraux de deux diodes voisines.

L'empilement de couches peut être réalisé sur un substrat initial tel que la première couche de semi-conducteur soit disposée entre la deuxième couche de semi-conducteur et le substrat initial. Le substrat initial peut notamment servir à réaliser la croissance des couches de semi-conducteur de l'empilement.

Le procédé peut comporter en outre, après la réalisation de la première électrode et de la deuxième partie de la deuxième électrode, une étape de report de la diode sur un substrat d'interconnexions telle que les première et deuxième électrodes de la diode soient reliées électriquement au substrat d'interconnexions, puis une étape de retrait du substrat initial.

L'invention porte également sur un procédé de réalisation d'un dispositif électronique, comportant la mise en œuvre d'un procédé tel que décrit ci-dessus, dans lequel les étapes mises en œuvre forment plusieurs diodes telles que chacune des premières électrodes est reliée électriquement à la première portion de semi-conducteur d'au moins une diode voisine uniquement par un contact avec les flancs latéraux de la deuxième partie de la première portion de semi-conducteur de ladite au moins une diode voisine.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

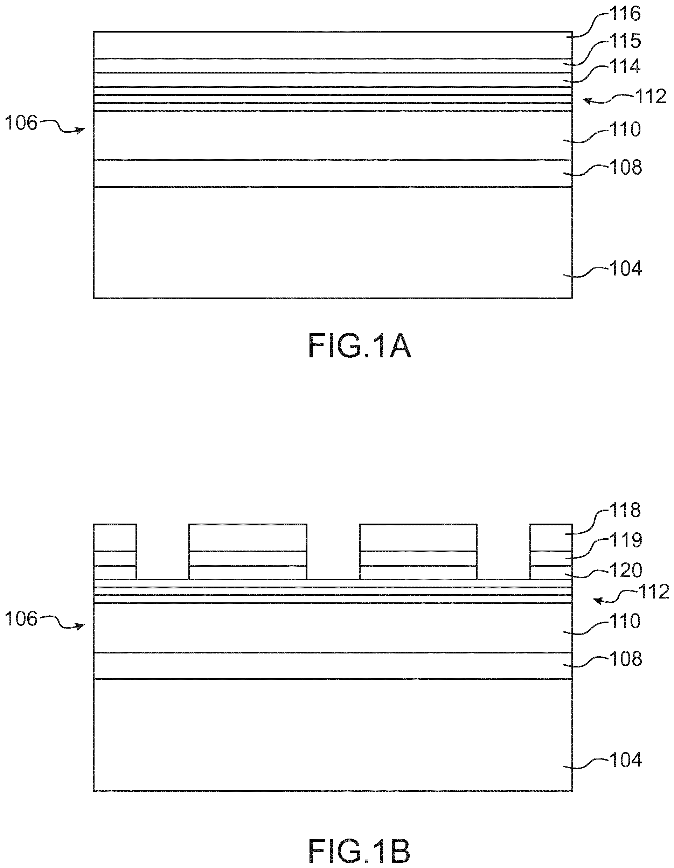

- les figures 1A à 1I représentent les étapes d'un procédé de réalisation d'un dispositif électronique, objet de la présente invention, comportant plusieurs diodes, également objets de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Les figures 1A à 1I représentent les étapes d'un procédé de réalisation d'un dispositif électronique 100 selon un mode de réalisation particulier. Dans le mode de réalisation particulier décrit ici, le dispositif 100 comporte plusieurs diodes 102 correspondant à des diodes électroluminescentes et formant une matrice de diodes servant de matrice de pixels du dispositif 100. En variante, les diodes 102 peuvent être réalisées les unes à côté des autres sans former une matrice de diodes, sans espacements réguliers entre elles.

Comme représenté sur la figure 1A, le dispositif 100 comporte un substrat initial 104 comprenant par exemple du saphir, du silicium, un semi-conducteur similaire à celui utilisé pour former la partie active des diodes 102, ou tout autre matériau permettant au substrat 104 de former un substrat de croissance permettant le dépôt de l'empilement semi-conducteur pour former la partie active des diodes 102. Le substrat 104 sert de support pour le dépôt ou la croissance de couches destinées à la réalisation des diodes 102 du dispositif 100.

Une première couche 106 de semi-conducteur dopé selon un premier type de conductivité, par exemple de type n, est déposée sur le substrat 104. Dans le mode de réalisation particulier décrit ici, cette couche 106 correspond à un empilement de plusieurs couches de semi-conducteur distinctes, par exemple une couche 108 de semi-conducteur dopé n+ avec une concentration de donneurs par exemple comprise entre environ 5.10¹⁷ et 5.10²⁰ donneurs/cm³ sur laquelle est disposée une autre couche 110 de semi-conducteur dopé n- avec une concentration de donneurs par exemple comprise entre environ 10¹⁷ et 5.10¹⁹ donneurs/cm³. Par exemple, la couche 108 peut être une couche de GaN et la couche 110 peut être une couche d'InGaN. L'épaisseur de la couche 108 est par exemple supérieure à environ 100 nm, par exemple égale à environ 3 µm, et celle de la couche 110 est par exemple comprise entre environ 5 nm et 500 nm. L'épaisseur totale de la première couche 106, c'est-à-dire la somme des épaisseurs des couches 108 et 110, est par exemple comprise entre environ 20 nm et 10 µm, et de préférence comprise entre environ 2 µm et 4 µm. La couche 108 forme ici une couche tampon disposée entre la couche 110 et le substrat 104 et servant notamment à filtrer les défauts de croissance afin que ces défauts ne se retrouvent pas la couche 110 servant à former les jonctions p-n des diodes 102.

En variante, les couches 108 et 110 peuvent être dopées avec un même niveau de dopage de type n (contrairement au cas décrit ci-dessus où la couche 108 est dopée n+ et la couche 110 est dopée n-). Selon une autre variante, la couche 106 peut correspondre à une seule couche de semi-conducteur dopé n, et avec une concentration de donneurs par exemple comprise entre environ 10¹⁷ et 5.10²⁰ donneurs/cm³, comportant par exemple du GaN et dont l'épaisseur est par exemple comprise entre environ 20 nm et 10 µm, et avantageusement comprise entre environ 2 µm et 4 µm.

Un empilement 112 comprenant une ou plusieurs couches émissives, par exemple cinq, destinées à former chacune dans les diodes 102 un puits quantique, par exemple à base d'InGaN, et chacune disposée entre deux couches barrières, par exemple à base de GaN, est disposé sur la première couche 106 (sur la couche 110 sur la figure 1A). L'empilement 112 est formé de couches comportant des matériaux semi-conducteurs intrinsèques, c'est-à-dire non intentionnellement dopés (de concentration en donneurs résiduels n_{nid} par exemple égale à environ 10¹⁷ donneurs/cm⁻³, ou comprise entre environ 10¹⁵ et 10¹⁸ donneurs/cm³). L'épaisseur de la ou de chacune des couches émissives est par exemple égale à environ 3 nm et plus généralement comprise entre environ 0,5 nm et 10 nm, et l'épaisseur de chacune des couches barrières est par exemple comprise entre environ 1 nm et 25 nm. Les couches de l'empilement 112 sont destinées à former les couches actives émissives des diodes 102.

Une deuxième couche 114 de semi-conducteur dopé selon un deuxième type de conductivité, opposé à celui du dopage de la première couche 106 et donc ici de type p, avec une concentration d'accepteurs par exemple comprise entre environ 10¹⁷ et 5.10¹⁹ accepteurs/cm³, est disposée sur l'empilement 112. Les couches 106 et 114 (et plus particulièrement les couches 110 et 114 dans l'exemple décrit ici) sont destinées à former les jonctions p-n des diodes 102. Le semi-conducteur de la couche 114 est par exemple du GaN et son épaisseur est par exemple comprise entre environ 20 nm et 10 µm.

Dans une variante de réalisation, une couche de blocage d'électrons (non visible sur les figures 1A à 1H) peut être disposée entre la deuxième couche 114 et l'empilement de couches 112, cette couche de blocage d'électrons étant par exemple en AIGaN avec 12% d'aluminium et dopée p avec une concentration d'accepteurs par exemple égale à environ1.10¹⁷ accepteurs/cm³.

Des matériaux autres que ceux cités ci-dessus peuvent être utilisés pour réaliser les diodes 102.

Une couche électriquement conductrice 115 destinée à former une partie de l'électrode qui sera en contact avec le semi-conducteur de la couche 114, est disposée sur la couche 114. Le matériau électriquement conducteur utilisé est optiquement réflecteur, et correspond par exemple à de l'aluminium. Ce matériau est qualifié d'optiquement réflecteur car la couche 115 présente un coefficient de réflexion en amplitude (rapport de l'amplitude de la lumière réfléchie sur l'amplitude de la lumière incidente) d'au moins 80 %.

Une couche 116 destinée à former un masque dur diélectrique est réalisée sur la couche 115. Le matériau de cette couche 116 est par exemple du SiO₂.

Comme représenté sur la figure 1B, des motifs sont formés par gravure dans la couche 116, formant le masque diélectrique 118. Les ouvertures formées dans le masque diélectrique 118 correspondent aux motifs à graver dans les couches sur lesquelles le masque diélectrique 118 est disposé afin de définir les structures mesa des diodes 102. Une gravure de la couche électriquement conductrice 115 est mise en œuvre selon le motif du masque diélectrique 118, conservant des portions restantes 119 de la couche 115 destinées à former des parties des anodes des diodes 102. Une gravure de la couche 114 est ensuite mise en œuvre selon les motifs définis par le masque diélectrique 118, réalisant des deuxièmes portions 120 de semi-conducteur dopées destinées à faire partie des jonctions p-n des diodes 102. Les couches 114, 115 et 116 sont par exemple gravées par la mise en œuvre d'une gravure ionique réactive par un système de torche à plasma, ou ICP-RIE pour « Inductively Coupled Plasma - Reactive Ion Etching ».

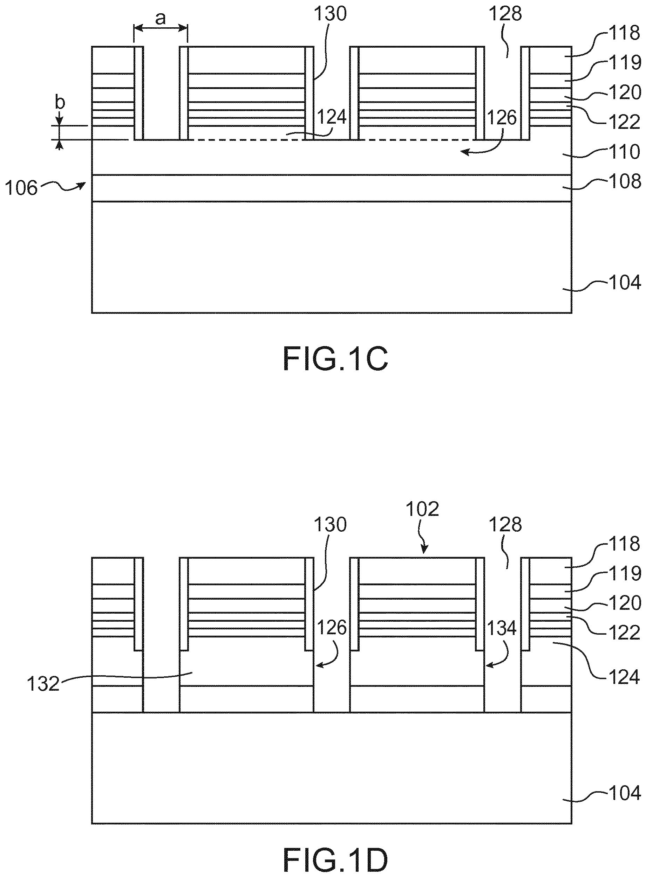

Comme représente sur la figure 1C, la gravure est ensuite prolongée dans l'empilement 112 et une première partie de la première couche 106 (ou une première de l'empilement de couches formant la première couche 106) toujours selon les motifs définis par le masque diélectrique 118. Cette gravure est stoppée à un niveau de profondeur situé dans la première couche 106 telle qu'une deuxième partie de la première couche 106 soit conservée au fond de chacune des zones gravées de l'empilement. Sur l'exemple décrit ici, la gravure est stoppée à un niveau se situant dans la couche 110 telle que la couche 108 et une partie de l'épaisseur de la couche 110 ne soient pas gravées. L'épaisseur, référencée « b » sur la figure 1C, de la couche 110 qui est gravée, c'est-à-dire l'épaisseur de la première partie de la première couche 106, est par exemple comprise entre environ 100 nm et 5 µm.

En variante, cette gravure peut être stoppée au niveau de la face supérieur de la couche 108 telle que cette couche 108 ne soit pas gravée mais que toute l'épaisseur de la couche 110 soit gravée. Selon une autre variante, cette gravure peut être stoppée à un niveau se situant dans la couche 108 telle que seule une partie de l'épaisseur de la couche 108 ne soit pas gravée.

Le choix de la profondeur de gravure réalisée, et donc de l'épaisseur de chacune des première et deuxième parties de la première couche 106, dépend notamment de l'épaisseur initiale de la première couche 106 (et donc des épaisseurs initiales des couches 108 et 110 dans le mode de réalisation décrit ici) et cela afin que l'épaisseur restante de la première couche 106, c'est-à-dire l'épaisseur de la deuxième partie de la première couche 106 soit suffisante pour réaliser un bon contact électrique entre cette deuxième partie de la première couche 106 et les cathodes des diodes 102 comme décrit plus loin.

Les portions restantes de l'empilement 112 forment des zones actives 122 des diodes 102 et les portions restantes de la première partie de la première couche 106 forment des premières parties 124 de premières portions 126 de semi-conducteur dopées destinées à former, avec les deuxièmes portions 120, les jonctions p-n des diodes 102 (sur la figure 1C, les premières parties 124 sont délimitées symboliquement du reste de la première couche 106 par des traits pointillés).

Les gravures réalisées dans les couches 106 (108+110), 112, 114 et 115 correspondent aux emplacements des cathodes des diodes 102 du dispositif 100. Cette gravure de ces couches forme, entre les structures mesa des diodes 102, des espaces 128 qui serviront par la suite à la réalisation des cathodes des diodes 102. Dans le mode de réalisation particulier décrit ici, les cathodes des diodes 102 formeront une cathode commune à plusieurs diodes 102, ou toutes les diodes 102, du dispositif 100.

Une dimension, référencée « a » sur la figure 1C, des espaces 128 correspondant à la distance entre deux structures mesa de diodes 102 voisines est par exemple supérieure ou égale à environ 50 nm, la distance minimale entre deux diodes 102 voisines étant définie par la résolution minimale de la lithographie mise en œuvre. Cette dimension « a » correspond à la somme de la largeur d'une portion de matériau électriquement conducteur qui sera réalisée entre les deux structures mesa des diodes 102 pour former une cathode commune à ces diodes 102 et des épaisseurs de deux portions diélectriques verticales qui seront également disposées entre les deux structures mesa des diodes 102. Ainsi, la dimension « a » est fonction de la largeur de la cathode réalisée entre les diodes 102 qui est choisie notamment en fonction des pertes acceptables liées à l'amenée du courant électrique dans les zones les plus éloignées des prises de contact périphériques. La gravure mise en œuvre est une gravure sèche, par exemple via un plasma à base de Cl₂ ou une gravure RIE, par exemple ICP-RIE.

Les dimensions des côtes d'une des structures mesa peuvent être comprises entre environ 500 nm et 1 mm, ou entre 500 nm et plusieurs millimètres, selon les applications visées. Pour des applications faisant appel à des diodes de forte puissance (par exemple des ampoules LEDs pour former des phares de voiture), les dimensions des diodes 102 seront plus importantes que pour des applications faisant appel à des diodes 102 de plus faible puissance.

Une couche diélectrique, correspondant par exemple à un bicouche SiN / SiO₂, et formant une couche de passivation, est ensuite déposée avec une épaisseur conforme, par exemple comprise entre environ 5 nm et 1 µm et avantageusement égale à environ 200 nm, sur le masque diélectrique 118 et le long des parois des espaces 128, recouvrant donc les parois latérales du masque diélectrique 118, des deuxièmes portions de semi-conducteur 120, des zones actives 122 et des premières parties 124 des premières portions de semi-conducteur 126. La couche diélectrique est également déposée sur les parties non gravées de la première couche 106 formant les parois de fond des espaces 128. Cette couche diélectrique est par exemple formé par un dépôt de type PECVD (dépôt chimique en phase vapeur assisté par plasma) ou ALD (dépôt de couche atomique) selon la nature du ou des matériaux déposés.

Une gravure anisotrope, par exemple une gravure sèche telle qu'une gravure RIE, est ensuite mise en œuvre telle que les parties de la couche diélectrique se trouvant dans les espaces 128 et ne recouvrant pas les parois latérales des structures mesa des diodes 102 soient supprimées, révélant ainsi les parties de la première couche 106 se trouvant au fond des espaces 128. Les parties de cette couche diélectrique recouvrant les faces supérieures du masque diélectrique 118 sont également supprimées. Ainsi, seules des portions 130 de la couche diélectrique recouvrant les parois latérales du masque diélectrique 118, des deuxièmes portions de semi-conducteur 120, des zones actives 122 et des premières parties 124 des premières portions de semi-conducteur 126 sont conservées dans les espaces 128.

Comme représenté sur la figure 1D, une deuxième gravure de la couche 106 est ensuite mise en œuvre jusqu'à ce que les parois de fond des espaces 128 soient formées par le substrat 104, c'est-à-dire à travers toute l'épaisseur de la deuxième partie de la première couche 106, formant ainsi des deuxièmes parties 132 des premières portions de semi-conducteur 126 qui comprennent les portions restantes de la deuxième partie de la première couche 106. Cette gravure permet de révéler des flancs latéraux 134 de ces deuxièmes parties 134 des premières portions 126 qui vont former des zones de contact électrique pour les cathodes des diodes 102.

Les portions du masque diélectrique 118, les portions de semi-conducteur 120 et 126, les zones actives 122 et les portions diélectriques 130 forment des structures mesa, c'est-à-dire des empilements sous forme d'îlots, disposées sur le substrat 104. Chaque structure mesa de chaque diode 102 a une section, dans un plan parallèle à la face du substrat 104 sur laquelle reposent ces structures, par exemple en forme de disque. Chacune des structures mesa peut donc former un îlot de forme cylindrique. Des structures mesa de forme différente sont envisageables, par exemple en forme de pavé.

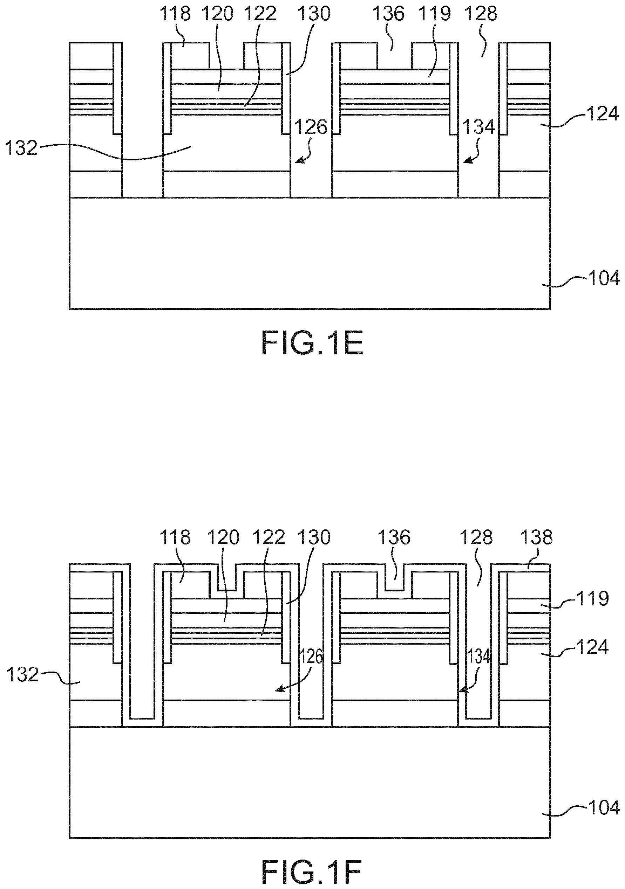

Des ouvertures 136 sont ensuite réalisées à travers le masque diélectrique 118, formant des emplacements pour la réalisation de deuxièmes parties des anodes des diodes 102 (figure 1E). Ces ouvertures 136 traversent toute l'épaisseur du masque diélectrique 118 afin que les parois de fond des ouvertures 136 soient formées par les portions 119. Cette gravure est par exemple de type ICP-RIE.

Un premier matériau électriquement conducteur 138 est ensuite déposé dans les espaces 128, entre les structures mesa des diodes 102, ainsi que sur les faces supérieures du masque diélectrique 118 et dans les ouvertures 136 (figure 1F). Ce premier matériau électriquement conducteur 138 est déposé de manière conforme, c'est-à-dire en formant une couche d'épaisseur sensiblement constante sur le masque diélectrique 118 et le long des parois des espaces 128 et des ouvertures 136. Dans l'exemple de réalisation décrit ici, le premier matériau électriquement conducteur 138 est formé par le dépôt d'une première couche de titane d'épaisseur par exemple comprise entre environ 5 nm et 300 nm, suivi d'un dépôt d'une deuxième couche d'aluminium d'épaisseur par exemple comprise entre environ 50 nm et 1 µm.

Le premier matériau électriquement conducteur 138 est en contact électriquement avec les flancs latéraux 134 des deuxièmes parties 134 des premières portions 126, et avec les portions 119 au niveau des parois de fond des ouvertures 136. Ces contacts électriques sont destinés à former les liaisons électriques entre les jonctions p-n et les anodes et cathodes des diodes 102.

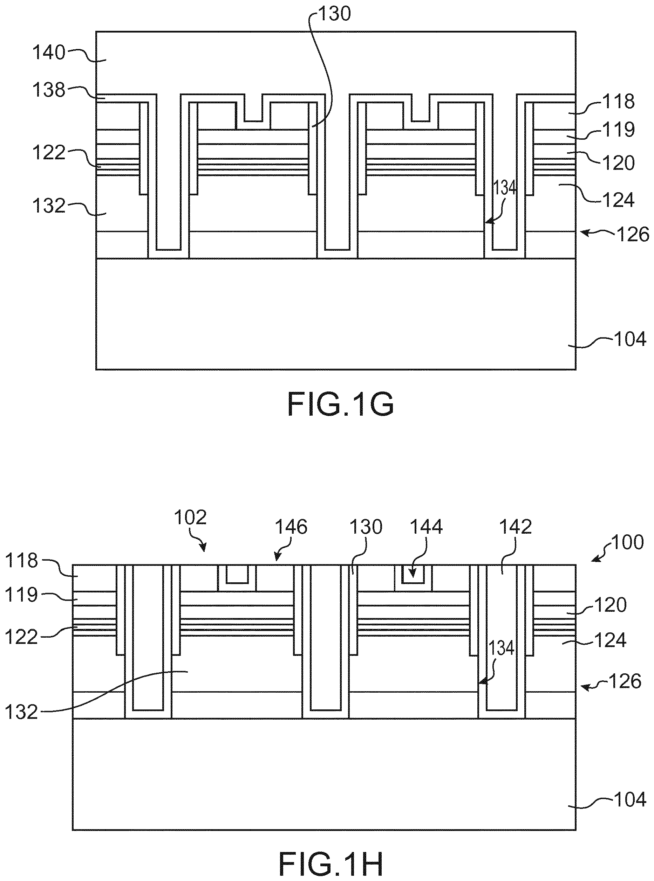

Comme représenté sur la figure 1G, un deuxième matériau électriquement conducteur 140 est déposé en remplissant le volume restant des espaces 128 et des ouvertures 136. Sur la figure 1G, l'épaisseur de ce deuxième matériau électriquement conducteur 140 est telle qu'il recouvre également les parties du premier matériau électriquement conducteur 138 disposées sur le masque diélectrique 118. Le deuxième matériau électriquement conducteur 140 est par exemple du cuivre qui peut être formé par la mise en œuvre d'un dépôt électrochimique (ECD ou « Electro-Chemical Deposition ») pleine plaque, c'est-à-dire sur l'ensemble de la structure précédemment réalisée.

Enfin, les diodes 102 du dispositif 100 sont achevées en mettant en œuvre une planarisation mécano-chimique (CMP) afin de supprimer les portions des premier et deuxième matériaux électriquement conducteurs 138 et 140 qui dépassent des espaces 128 et des ouvertures 134 et qui sont disposées sur le masque diélectrique 118. Cette planarisation permet d'isoler électriquement les portions de matériau conducteur disposées dans les espaces 128 vis-à-vis de celles disposées dans les ouvertures 136 (figure 1H). Les portions des matériaux électriquement conducteurs 138 et 140 disposées dans les espaces 128 forment des cathodes 142 s'étendant sur toute la hauteur des structures mesa des diodes 102 et sont reliées électriquement aux premières portions de semi-conducteur 126 uniquement au niveau des flancs latéraux 134. Les portions des matériaux électriquement conducteurs 138 et 140 disposées dans les ouvertures 136 forment des deuxièmes parties des anodes 144 reliées électriquement aux portions 119 correspondant aux premières parties des anodes 144, les anodes 144 étant reliées aux deuxièmes portions de semi-conducteur 120 au niveau des faces supérieures de ces portions 120. On obtient une face 146 du dispositif 100 réalisé qui est sensiblement plane, formée par les faces supérieures des cathodes 142, des anodes 144, des portions diélectriques 130 et du masque diélectrique 118. Cette face 146 forme les faces arrières des diodes 102 au niveau desquelles des connexions électriques avec les cathodes 142 et les anodes 144 seront réalisées.

Grâce aux portions diélectriques 130 verticales, les cathodes 142 sont bien isolées électriquement des deuxièmes portions de semi-conducteur 120, des anodes 144 et des zones actives 122. L'épaisseur des portions diélectriques 130, qui correspond à l'épaisseur de la couche diélectrique servant la réalisation des portions 130, peut être choisie telle qu'un courant de fuite acceptable soit toléré sur chacune des diodes 102, par exemple inférieur à environ 1 % du courant nominal traversant la diode 102, lorsqu'elles sont soumises à une différence de potentiels (appliquée entre la cathode et l'anode) par exemple de l'ordre de 4 Volts. L'épaisseur minimale des portions diélectriques 130 est par exemple comprise entre environ 3 nm et 5 nm, ou entre 3 nm et 4 nm, en fonction du ou des matériaux utilisés pour réaliser les portions diélectriques 130.

Afin de garantir une isolation électrique entre les cathodes 142 et les anodes 144 des diodes 102, et éviter la présence de parties des matériaux électriquement conducteurs 138 et 140 reliant électriquement une ou plusieurs des cathodes 142 avec une ou plusieurs des anodes 144, l'étape de planarisation est avantageusement mise en œuvre jusqu'à réaliser une sur-gravure des portions des matériaux électriquement conducteurs 138 et 140 disposées dans les espaces 128 et dans les ouvertures 136 par rapport aux matériaux diélectriques des portions 130 et du masque 118, formant dans les cathodes 142 et les anodes 144 des creux au niveau des faces supérieures de ces électrodes. Ces creux peuvent avoir une profondeur, par rapport au plan de la face supérieure 146, comprise entre environ 5 nm et 150 nm. Cette sur-gravure peut être obtenue en jouant sur l'anisotropie de gravure et grâce à la sélectivité de gravure qui existe entre les matériaux diélectriques des portions 130 et du masque 118 et les matériaux électriquement conducteurs 138 et 140. La CMP mise en œuvre présente une vitesse d'abrasion différente en fonction des matériaux, et dans le procédé décrit ici, l'abrasion des matériaux électriquement conducteurs 138 et 140 est plus rapide que celle des matériaux diélectriques des portions 130 et du masque 118. Cela se traduit, au niveau de la face supérieure 146 du dispositif 100, par un retrait des matériaux 138 et 140 par rapport aux portions diélectriques 130 et au masque diélectrique 118. Ainsi, les électrodes des diodes 102 restent parfaitement isolées les unes des autres grâce à une propriété intrinsèque de la planarisation mise en œuvre. Une telle sur-gravure peut également être mise en œuvre par un procédé de gravure RIE.

Dans le mode de réalisation particulier décrit ci-dessus, les premières portions de semi-conducteur 126 sont de type n et les deuxièmes portions de semi-conducteur 120 sont de type p. En variante, les premières portions de semi-conducteur 126 peuvent être de type p et les deuxièmes portions de semi-conducteur 120 peuvent être de type n, avec dans ce cas les portions de matériau électriquement conducteur disposées dans les espaces 128 formant les anodes des diodes 102 et les portions de matériau électriquement conducteur disposées dans les ouvertures 136 formant, avec les portions 119, les cathodes des diodes 102.

La surface sensiblement plane obtenue au niveau de la face supérieure 146 du dispositif 100 permet d'hybrider aisément la matrice de diodes 102 réalisée à tout type d'élément tel qu'un circuit électronique, et permet notamment de réaliser une telle hybridation par collage direct (« direct bonding », également appelé collage par adhésion moléculaire) de la matrice de diodes 102 au circuit électronique sans faire appel à des inserts, tels que des microbilles, entre la matrice de diodes 102 et le circuit électronique. Les collages directs de type métal-métal et diélectrique-diélectrique réalisés dans ce cas ont l'avantage d'être étanches. Le fait que des creux soient présents au niveau des faces supérieures des cathodes 142 et des anodes 144 ne pose pas de problème pour la mise en œuvre d'un tel collage direct car lors de ce collage direct, les matériaux de ces portions se dilatent et il est donc possible d'obtenir un très bon contact entre ces électrodes et des éléments conducteurs du circuit électronique. Des détails de mise en œuvre d'un tel collage direct sont par exemple décrits dans le document « Mechanisms of copper direct bonding observed by in-situ and quantitative transmission electron microscopy » de M. Martinez et al., Thin Solid Films 530 (2013) 96-99.

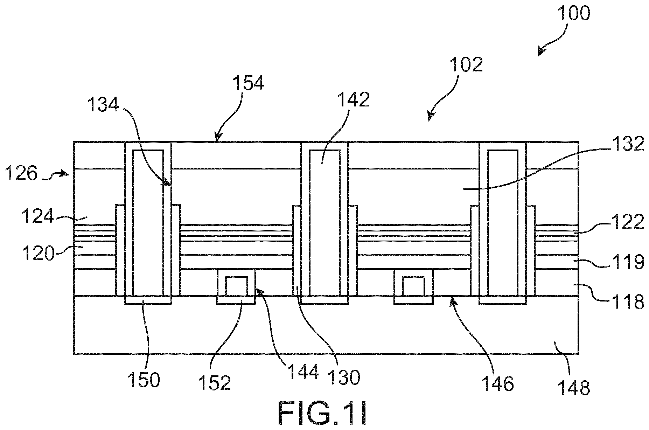

Comme représenté sur la figure 1I, la matrice de diodes 102 est reportée, au niveau de sa face supérieure 146, sur un substrat d'interconnexions 148 comportant des contacts électriques 150 et 152 auxquels les cathodes 142 et les anodes 144 peuvent être reliées électriquement, par exemple via un collage direct comme décrit ci-dessus. Ce substrat d'interconnexions 148 peut correspondre à un circuit électronique sur lequel la matrice de diodes 102 est reportée.

Après ce report, le substrat initial 104 peut être retiré, libérant ainsi une face avant 154 des diodes par laquelle la lumière est destinée à entrer ou sortir. Le type de retrait mis en œuvre peut dépendre notamment de la nature du substrat initial 104. Par exemple, dans le cas d'un substrat initial 104 de saphir, celui-ci peut être retiré par décollement (« lift-off » en anglais). Il est également possible que le substrat initial 104 soit retiré par meulage (« grinding » en anglais), ou encore par gravure sélective.

Du fait que la face avant 154 soit libérée en n'étant plus recouverte par le substrat 104, il est donc possible de réaliser, lorsque la diode 102 correspond à une diode photo-émettrice, sur cette face avant 154 des motifs d'extraction de la lumière, c'est-à-dire des motifs permettant d'augmenter la quantité de lumière émise par la diode 102. Pour cela, après avoir retiré le substrat initial 104, il est possible de réaliser un traitement de surface de la face avant 154 permettant l'amélioration de l'extraction lumineuse via des phénomènes réfractifs ou diffractifs. Dans le cas de phénomènes réfractifs, il est par exemple possible de créer une rugosité aléatoire de la surface de la face avant 154 pouvant être obtenue par une attaque chimique, par exemple avec du KOH. Cette rugosité peut correspondre à des motifs aléatoires de dimensions, dans toutes les directions, comprises entre environ 100 nm et 2 µm. Dans le cas de phénomène diffractifs, il est possible de réaliser des motifs organisés de très faibles dimensions, par exemple comprises entre environ 50 nm et 500 nm. Que les motifs réalisés soient de type réfractifs ou diffractifs, il est possible de rajouter un globe de silicone permettant de collecter la lumière et protéger la surface de la face avant 154.

Dans le mode de réalisation particulier décrit ici, le dispositif 100 comporte une matrice de diodes 102 qui sont des diodes électroluminescentes, le dispositif microélectronique pouvant faire partie d'un dispositif d'affichage à LEDs (écrans, projecteur, mur d'images, etc.). Cette matrice de diodes 102 comporte les cathodes 142 qui forment une cathode commune à toutes les diodes 102, et chaque diode 102 comporte une anode 144 permettant de réaliser l'adressage individuel de chacune des diodes 102.

En variante, le dispositif microélectronique 100 peut comporter une matrice de diodes 102 qui sont des diodes photo-réceptrices, ou photodiodes. Dans ce cas, l'empilement de couches 112 disposé entre les couches de semi-conducteur 106 et 114 respectivement dopées n et p peut correspondre à une ou plusieurs couches de semi-conducteur intrinsèque. De plus, dans cette variante, les anodes 144 et les cathodes 142 des diodes 102 ne servent pas à fournir du courant aux diodes 102 mais servent à récupérer les courants photo-générés par les diodes 102.

Selon une autre variante, que les diodes 102 correspondent à des diodes électroluminescentes ou à des photodiodes, les structures mesa des diodes 102 peuvent ne pas comporter de couches entre les portions de semi-conducteur dopées 120 et 126 (correspondant aux zones actives émissives ou aux portions de semi-conducteur intrinsèque), et les semi-conducteurs dopés p et n sont alors disposés directement l'un contre l'autre.

En variante, le dispositif 100 peut comporter, sur la face supérieure 134, une structure de connexion formant les connexions électriques des diodes 102 et comportant des premiers éléments électriquement conducteurs reliés électriquement aux cathodes 142 des diodes 102 et des deuxièmes éléments électriquement conducteurs reliés électriquement aux anodes 144 des diodes 102. Ces éléments électriquement conducteurs d'une telle structure de connexion sont isolés électriquement les uns des autres par des éléments diélectriques dont les dimensions, dans le plan de la face 134, sont au moins égales à celles des portions diélectriques 130 et du masque dur 118 afin que les éléments électriquement conducteurs ne forment pas de courts-circuits entre les électrodes des diodes 102.

## Revendications

1. Diode (102) photo-émettrice ou photo-réceptrice, comportant au moins :
- une première et une deuxième portions de semi-conducteur (120, 126) dopées formant une jonction p-n, une première partie (124) de la première portion de semi-conducteur (126) étant disposée entre une deuxième partie (132) de la première portion de semi-conducteur (126) et la deuxième portion de semi-conducteur (120) ;
- des portions diélectriques (130) recouvrant des flancs latéraux de la deuxième portion de semi-conducteur (120) et de la première partie (124) de la première portion de semi-conducteur (126) ;
- une première électrode (142) disposée contre des flancs latéraux extérieurs des portions diélectriques (130) et contre des flancs latéraux (134) de la deuxième partie (132) de la première portion de semi-conducteur (126), reliée électriquement à la première portion de semi-conducteur (126) uniquement par un contact avec les flancs latéraux (134) de la deuxième partie (132) de la première portion de semi-conducteur (126), et traversant toute l'épaisseur de la première portion de semi-conducteur (126) ;
- une deuxième électrode (144) optiquement réflectrice reliée électriquement à la deuxième portion de semi-conducteur (120) telle que la deuxième portion de semi-conducteur (120) soit disposée entre la deuxième électrode (144) et la première portion de semi-conducteur (126) et comportant une première partie (119) recouvrant entièrement une face de la deuxième portion de semi-conducteur (120) et dont les flancs latéraux sont recouverts par les portions diélectriques (130), et une deuxième partie disposée sur la première partie (119) ;
et dans laquelle une lumière est destinée à être émise ou reçue par la diode (102) à travers la première portion de semi-conducteur (126).

2. Diode (102) selon la revendication 1, comportant en outre un masque diélectrique (118) tel que la première partie (119) de la deuxième électrode (144) soit disposée entre le masque diélectrique (118) et la deuxième portion de semi-conducteur (120), qu'au moins une deuxième partie de la deuxième électrode (144) soit disposée dans au moins une ouverture (136) traversant le masque diélectrique (118), et que les portions diélectriques (130) recouvrent des flancs latéraux du masque diélectrique (118).

3. Diode (102) selon la revendication 2, dans lequel des faces supérieures du masque diélectrique (118), des portions diélectriques (130) et des première et deuxième électrodes (142, 144) forment ensemble une surface continue sensiblement plane de la diode (102).

4. Diode (102) selon l'une des revendications précédentes, dans laquelle les flancs latéraux extérieurs des portions diélectriques (130) sont alignés avec les flancs latéraux (134) de la deuxième partie (132) de la première portion de semi-conducteur (126).

5. Diode (102) selon l'une des revendications précédentes, dans laquelle la première portion de semi-conducteur (126) comporte un empilement d'au moins deux semi-conducteurs (108, 110) dopés selon des niveaux de conductivité différents.

6. Diode (102) selon l'une des revendications précédentes, dans laquelle l'épaisseur de la première portion de semi-conducteur (126) est comprise entre environ 2 µm et 4 µm.

7. Diode (102) selon l'une des revendications précédentes, dans laquelle la diode (102) est une photodiode ou une LED.

8. Diode (102) selon la revendication 7, dans laquelle la photodiode comporte au moins une portion de semi-conducteur intrinsèque disposée entre les première et deuxième portions de semi-conducteur (120, 126) et telle que des flancs latéraux de la portion de semi-conducteur intrinsèque soient recouverts par les portions diélectriques (130), ou dans laquelle la LED comporte au moins une zone active émissive (122) à au moins un puits quantique disposée entre les première et deuxième portions de semi-conducteur (120, 126) et telle que des flancs latéraux de la zone active émissive (122) soient recouverts par les portions diélectriques (130).

9. Diode (102) selon l'une des revendications précédentes, comportant en outre un substrat d'interconnexions (148) sur lequel la diode est disposée et auquel les première et deuxième électrodes (142, 144) de la diode (102) sont reliées électriquement.

10. Dispositif électronique (100) comportant plusieurs diodes (102) selon l'une des revendications précédentes, dans lequel chacune des premières électrodes (142) est en outre reliée électriquement à la première portion de semi-conducteur (126) d'au moins une diode (102) voisine uniquement par un contact avec les flancs latéraux (134) de la deuxième partie (132) de la première portion de semi-conducteur (126) de ladite au moins une diode (102) voisine.

11. Dispositif électronique (100) selon la revendication 10, dans lequel les diodes (102) font partie d'une matrice de diodes (102) de structures similaires formant une matrice de pixels du dispositif électronique (100).

12. Procédé de réalisation d'une diode (102) photo-émettrice ou photo-réceptrice, comportant au moins les étapes de :
- réalisation d'un empilement de couches comprenant au moins des première et deuxième couches de semi-conducteur (106, 114) dopées selon des types de conductivité opposés et au moins une couche électriquement conductrice et optiquement réflectrice (115), telles que la deuxième couche de semi-conducteur (114) soit disposée entre la première couche de semi-conducteur (106) et la couche électriquement conductrice et optiquement réflectrice (115) ;
- première gravure de l'empilement de couches à travers la couche électriquement conductrice (115), la deuxième couche de semi-conducteur (114) et une partie de l'épaisseur de la première couche de semi-conducteur (106), formant une première partie (119) d'une deuxième électrode (144) de la diode (102), une deuxième portion de semi-conducteur (120) dont une face est entièrement recouverte par la première partie (119) de la deuxième électrode (144), et une première partie (124) d'une première portion de semi-conducteur (126) à travers laquelle une lumière est destinée à être émise ou reçue par la diode (102) ;
- réalisation de portions diélectriques (130) recouvrant des flancs latéraux de la première partie (119) de la deuxième électrode (144), de la deuxième portion de semi-conducteur (120) et de la première partie (124) de la première portion de semi-conducteur (126) ;
- deuxième gravure de l'empilement de couches à travers une épaisseur restante de la première couche de semi-conducteur (106), formant une deuxième partie (132) de la première portion de semi-conducteur (126) telle que la première partie (124) de la première portion de semi-conducteur (126) soit disposée entre la deuxième partie (132) de la première portion de semi-conducteur (126) et la première partie (119) de la deuxième électrode (144), les première et deuxième portions de semi-conducteur (120, 126) formant une jonction p-n ;
- réalisation d'une première électrode (142) disposée contre des flancs latéraux extérieurs des portions diélectriques (130) et contre des flancs latéraux (134) de la deuxième partie (132) de la première portion de semi-conducteur (126), la première électrode (142) étant reliée électriquement à la première portion de semi-conducteur (126) uniquement par un contact avec les flancs latéraux (134) de la deuxième partie (132) de la première portion de semi-conducteur (126) et traversant toute l'épaisseur de la première portion de semi-conducteur (126), et réalisation d'une deuxième partie de la deuxième électrode (144) sur la première partie (119) de la deuxième électrode (144).

13. Procédé selon la revendication 12, dans lequel la première gravure de l'empilement de couches est mise en œuvre à travers un masque diélectrique (118) disposé sur l'empilement de couches, et dans lequel les portions diélectriques (130) recouvrent des flancs latéraux du masque diélectrique (118).

14. Procédé selon la revendication 13, dans lequel la deuxième gravure de l'empilement est réalisée telle que les flancs latéraux extérieurs des portions diélectriques (130) soient alignés avec les flancs latéraux (134) de la deuxième partie (132) de la première portion de semi-conducteur (126).

15. Procédé selon l'une des revendications 13 ou 14, dans lequel la réalisation de la première électrode (142) et de la deuxième partie de la deuxième électrode (144) comporte la mise en œuvre des étapes suivantes :
- réalisation d'une ouverture (136) à travers le masque diélectrique (118) et débouchant sur la première partie (119) de la deuxième électrode (144) ;
- dépôt d'au moins un matériau électriquement conducteur (138, 140) dans l'ouverture (136) et dans un espace (128) formé à travers l'empilement de couches par la mise en œuvre des première et deuxième gravures ;
- planarisation du matériau électriquement conducteur (138, 140) avec arrêt sur le masque diélectrique (118).

16. Procédé selon l'une des revendications 12 à 15, dans lequel l'empilement de couches est réalisé sur un substrat initial (104) tel que la première couche de semi-conducteur (106) soit disposée entre la deuxième couche de semi-conducteur (114) et le substrat initial (104).

17. Procédé selon la revendication 16, comportant en outre, après la réalisation de la première électrode (142) et de la deuxième partie de la deuxième électrode (144), une étape de report de la diode (102) sur un substrat d'interconnexions (148) tel que les première et deuxième électrodes (142, 144) de la diode (102) soient reliées électriquement au substrat d'interconnexions (148), puis une étape de retrait du substrat initial (104).

18. Procédé de réalisation d'un dispositif électronique (100), comportant la mise en œuvre d'un procédé selon l'une des revendications 12 à 17, dans lequel les étapes mises en œuvre forment plusieurs diodes (102) telles que chacune des premières électrodes (142) est reliée électriquement à la première portion de semi-conducteur (126) d'au moins une diode (102) voisine uniquement par un contact avec les flancs latéraux (134) de la deuxième partie (132) de la première portion de semi-conducteur (126) de ladite au moins une diode (102) voisine.

## Patentansprüche

1. Eine lichtemittierende oder lichtempfangende Diode (102), wenigstens umfassend:
- einen ersten und einen zweiten dotierten Halbleiterabschnitt (120, 126), die einen p-n-Übergang bilden, wobei ein erster Teil (124) des ersten Halbleiterabschnitts (126) zwischen einem zweiten Teil (132) des ersten Halbleiterabschnitts (126) und dem zweiten Halbleiterabschnitt (120) angeordnet ist;
- dielektrische Abschnitte (130), die Seitenflanken des zweiten Halbleiterabschnitts (120) und des ersten Teils (124) des ersten Halbleiterabschnitts (126) bedecken;
- eine erste Elektrode (142), die gegen äußere Seitenflanken der dielektrischen Abschnitte (130) und gegen Seitenflanken (134) des zweiten Teils (132) des ersten Halbleiterabschnitts (126) angeordnet ist, elektrisch mit dem ersten Halbleiterabschnitt (126) nur durch einen Kontakt mit den Seitenflanken (134) des zweiten Teils (132) des ersten Halbleiterabschnitts (126) verbunden ist und durch die gesamte Dicke des ersten Halbleiterabschnitts (126) verläuft;
- eine optisch reflektierende zweite Elektrode (144), die mit dem zweiten Halbleiterabschnitt (120) elektrisch verbunden ist, so dass der zweite Halbleiterabschnitt (120) zwischen der zweiten Elektrode (144) und dem ersten Halbleiterabschnitt (126) angeordnet ist und einen ersten Teil (119) aufweist, der eine Fläche des zweiten Halbleiterabschnitts (120) vollständig bedeckt und dessen Seitenflanken von den dielektrischen Abschnitten (130) bedeckt sind, und einen zweiten Teil, der auf dem ersten Teil (119) angeordnet ist;
und wobei Licht dazu bestimmt ist, von der Diode (102) durch den ersten Halbleiterabschnitt (126) emittiert oder geregelt zu werden.

2. Diode (102) nach Anspruch 1, ferner umfassend eine dielektrische Maske (118), so dass der erste Teil (119) der zweiten Elektrode (144) zwischen der dielektrischen Maske (118) und dem zweiten Halbleiterabschnitt (120) angeordnet ist, dass wenigstens ein zweiter Teil der zweiten Elektrode (144) in wenigstens einer Öffnung (136) angeordnet ist, die durch die dielektrische Maske (118) verläuft, und dass die dielektrischen Abschnitte (130) Seitenflanken der dielektrischen Maske (118) bedecken.

3. Diode (102) nach Anspruch 2, wobei die Oberseiten der dielektrischen Maske (118), die dielektrischen Abschnitte (130) und die erste und zweite Elektrode (142, 144) zusammen eine kontinuierliche, im Wesentlichen planare Oberfläche der Diode (102) bilden.

4. Diode (102) nach einem der vorhergehenden Ansprüche, wobei die äußeren Seitenflanken der dielektrischen Abschnitte (130) mit den Seitenflanken (134) des zweiten Teils (132) des ersten Halbleiterabschnitts (126) ausgerichtet sind.

5. Diode (102) nach einem der vorhergehenden Ansprüche, wobei der erste Halbleiterabschnitt (126) einen Stapel aus wenigstens zwei auf unterschiedliche Leitfähigkeitsniveaus dotierten Halbleitern (108, 110) umfasst.

6. Diode (102) nach einem der vorhergehenden Ansprüche, wobei die Dicke des ersten Halbleiterabschnitts (126) zwischen etwa 2 µm und 4 µm liegt.

7. Diode (102) nach einem der vorhergehenden Ansprüche, wobei die Diode (102) eine Fotodiode oder eine LED ist.

8. Diode (102) nach Anspruch 7, wobei die Fotodiode wenigstens einen intrinsischen Halbleiterabschnitt umfasst, der zwischen dem ersten und zweiten Halbleiterabschnitt (120, 126) angeordnet ist, derart, dass Seitenflanken des intrinsischen Halbleiterabschnitts von dielektrischen Abschnitten (130) bedeckt sind, oder wobei die LED wenigstens einen emissiven aktiven Bereich (122) mit wenigstens einer Quantenmulde umfasst, die zwischen dem ersten und zweiten Halbleiterabschnitt (120, 126) angeordnet ist, derart, dass die Seitenflanken des emissiven aktiven Bereichs (122) von den dielektrischen Abschnitten (130) bedeckt sind.

9. Diode (102) nach einem der vorhergehenden Ansprüche, ferner umfassend ein Verbindungssubstrat (148), auf dem die Diode angeordnet ist und mit dem die erste und zweite Elektrode (142, 144) der Diode (102) elektrisch verbunden sind.

10. Elektronische Vorrichtung (100) mit einer Vielzahl von Dioden (102) nach einem der vorhergehenden Ansprüche, wobei jede der ersten Elektroden (142) ferner mit dem ersten Halbleiterabschnitt (126) wenigstens einer benachbarten Diode (102) ausschließlich durch Kontakt mit den Seitenflanken (134) des zweiten Teils (132) des ersten Halbleiterabschnitts (126) der wenigstens einen benachbarten Diode (102) elektrisch verbunden ist.

11. Elektronische Vorrichtung (100) nach Anspruch 10, wobei die Dioden (102) Teil einer Matrix von Dioden (102) mit ähnlichen Strukturen sind, die eine Matrix von Pixeln der elektronischen Vorrichtung (100) bilden.

12. Verfahren zur Herstellung einer lichtemittierenden oder lichtempfangenden Diode (102), welches wenigstens die folgenden Schritte umfasst:
- Herstellen eines Schichtstapels, der wenigstens eine erste und eine zweite mit entgegengesetzten Leitfähigkeitstypen dotierte Halbleiterschicht (106, 114) umfasst und wenigstens eine elektrisch leitfähige und optisch reflektierende Schicht (115), so dass die zweite Halbleiterschicht (114) zwischen der ersten Halbleiterschicht (106) und der elektrisch leitfähigen und optisch reflektierenden Schicht (115) angeordnet ist;
- erstes Ätzen des Schichtstapels durch die elektrisch leitende Schicht (115), die zweite Halbleiterschicht (114) und einen Teil der Dicke der ersten Halbleiterschicht (106), dadurch Bilden eines ersten Teils (119) einer zweiten Elektrode (144) der Diode (102), eines zweiten Halbleiterabschnitts (120), dessen eine Fläche vollständig von dem ersten Teil (119) der zweiten Elektrode (144) bedeckt ist, und eines ersten Teils (124) eines ersten Halbleiterabschnitts (126), durch den Licht von der Diode (102) emittiert oder empfangen werden soll;
- Herstellen von dielektrischen Abschnitten (130), die Seitenflanken des ersten Teils (119) der zweiten Elektrode (144), des zweiten Halbleiterabschnitts (120) und des ersten Teils (124) des ersten Halbleiterabschnitts (126) bedecken;
- zweites Ätzen des Schichtstapels durch eine Restdicke der ersten Halbleiterschicht (106), dadurch Bilden eines zweiten Teils (132) des ersten Halbleiterabschnitts (126) derart, dass der erste Teil (124) des ersten Halbleiterabschnitts (126) zwischen dem zweiten Teil (132) des ersten Halbleiterabschnitts (126) und dem ersten Teil (119) der zweiten Elektrode (144) angeordnet ist, wobei der erste und der zweite Halbleiterabschnitt (120, 126) einen p-n-Übergang bilden;
- Vorsehen einer ersten Elektrode (142), die an äußeren Seitenflanken der dielektrischen Abschnitte (130) und an Seitenflanken (134) des zweiten Teils (132) des ersten Halbleiterabschnitts (126) angeordnet ist, wobei die erste Elektrode (142) mit dem ersten Halbleiterabschnitt (126) nur durch Kontakt mit den Seitenflanken (134) des zweiten Teils (132) des ersten Halbleiterabschnitts (126) elektrisch verbunden ist und durch die gesamte Dicke des ersten Halbleiterabschnitts (126) hindurch geht, und einen zweiten Teil der zweiten Elektrode (144) auf dem ersten Teil (119) der zweiten Elektrode (144) bildet.

13. Verfahren nach Anspruch 12, wobei das erste Ätzen des Schichtstapels durch eine auf dem Schichtstapel angeordnete dielektrische Maske (118) durchgeführt wird und wobei die dielektrischen Abschnitte (130) Seitenflanken der dielektrischen Maske (118) bedecken.

14. Verfahren nach Anspruch 13, wobei das zweite Ätzen des Stapels derart durchgeführt wird, dass die äußeren Seitenflanken der dielektrischen Abschnitte (130) mit den Seitenflanken (134) des zweiten Teils (132) des ersten Halbleiterabschnitts (126) ausgerichtet sind.

15. Verfahren nach einem der Ansprüche 13 oder 14, wobei die Herstellung der ersten Elektrode (142) und des zweiten Teils der zweiten Elektrode (144) die folgenden Schritte umfasst:
- Herstellen einer Öffnung (136) durch die dielektrische Maske (118), die zu dem ersten Teil (119) der zweiten Elektrode (144) führt;
- Ablagerung wenigstens eines elektrisch leitfähigen Materials (138, 140) in der Öffnung (136) und in einem durch den Schichtstapel gebildeten Raum (128) durch die Anwendung der ersten und zweiten Ätzung;
- Planarisierung des elektrisch leitfähigen Materials (138, 140) mit Halt auf der dielektrischen Maske (118).

16. Verfahren nach einem der Ansprüche 12 bis 15, wobei der Schichtstapel auf einem Ausgangssubstrat (104) so hergestellt wird, dass die erste Halbleiterschicht (106) zwischen der zweiten Halbleiterschicht (114) und dem Ausgangssubstrat (104) angeordnet ist.

17. Verfahren nach Anspruch 16, ferner umfassend, nach der Realisierung der ersten Elektrode (142) und des zweiten Teils der zweiten Elektrode (144), einen Schritt des Übertragens der Diode (102) auf ein Verbindungssubstrat (148), so dass die erste und die zweite Elektrode (142, 144) der Diode (102) elektrisch mit dem Verbindungssubstrat (148) verbunden sind, gefolgt von einem Schritt des Entfernens des Ausgangssubstrats (104).

18. Verfahren zur Herstellung einer elektronischen Vorrichtung (100), wobei ein Verfahren nach einem der Ansprüche 12 bis 17 durchgeführt wird, wobei die durchgeführten Schritte eine Vielzahl von Dioden (102) bilden, so dass jede der ersten Elektroden (142) mit dem ersten Halbleiterabschnitt (126) von wenigstens einer benachbarten Diode (102) ausschließlich durch Kontakt mit den Seitenflanken (134) des zweiten Teils (132) des ersten Halbleiterabschnitts (126) der wenigstens einen benachbarten Diode (102) elektrisch verbunden ist.

## Claims

1. Light-emitting or light-receiving diode (102), comprising at least:
- a first and second doped semi-conductor portions (120, 126) forming a p-n junction, a first part (124) of the first semi-conductor portion (126) being arranged between a second part (132) of the first semi-conductor portion (126) and the second semi-conductor portion (120);
- dielectric portions (130) covering side walls of the second semi-conductor portion (120) and the first part (124) of the first semi-conductor portion (126);
- a first electrode (142) arranged against the outer side walls of the dielectric portions (130) and against side walls (134) of the second part (132) of the first semi-conductor portion (126), electrically connected to the first semi-conductor portion (126) only by a contact with the side walls (134) of the second part (132) of the first semi-conductor portion (126), and passing through the entire thickness of the first semi-conductor portion (126);
- a second optically reflecting electrode (144), electrically connected to the second semi-conductor portion (120) such that the second semi-conductor portion (120) is arranged between the second electrode (144) and the first semi-conductor portion (126), and comprising a first part (119) entirely covering a face of the second semi-conductor portion (120) and of which side walls are covered by the dielectric portions (130), and a second part arranged on the first part (119);
and wherein a light is intended to be emitted or received by the diode (102) through the first semi-conductor portion (126).

2. Diode (102) according to claim 1, further comprising a dielectric mask (118) such that the first part (119) of the second electrode (144) is arranged between the dielectric mask (118) and the second semi-conductor portion (120), that at least one second part of the second electrode (144) is arranged in at least one opening (136) passing through the dielectric mask (118), and that the dielectric portions (130) cover the side walls of the dielectric mask (118).

3. Diode (102) according to claim 2, wherein upper faces of the dielectric mask (118), of the dielectric portions (130) and of the first and second electrodes (142, 144) jointly form a substantially planar continuous surface of the diode (102).

4. Diode (102) according to one of the previous claims, wherein the outer side walls of the dielectric portions (130) are aligned with the side walls (134) of the second part (132) of the first semi-conductor portion (126).

5. Diode (102) according to one of the previous claims, wherein the first semi-conductor portion (126) comprises a stack of at least two doped semiconductors (108, 110) according to different conductivity levels.

6. Diode (102) according to one of the previous claims, wherein the thickness of the first semi-conductor portion (126) lies in the range 2 µm to 4 µm approximately.

7. Diode (102) according to one of the previous claims, wherein the diode (102) is a photodiode or a LED.

8. Diode (102) according to claim 7, wherein the photodiode comprises at least one intrinsic semi-conductor portion arranged between the first and second semi-conductor portions (120, 126) and such that side walls of the intrinsic semi-conductor portion are covered by the dielectric portions (130), or wherein the LED comprises at least one active emitting area (122) at at least one quantum well arranged between the first and second semi-conductor portions (120, 126) and such that side walls of the active emitting area (122) are covered by the dielectric portions (130).

9. Diode (102) according to one of the previous claims, further comprising an interconnect substrate (148) on which the diode is arranged and to which the first and second electrodes (142, 144) of the diode (102) are electrically connected.

10. Electronic device (100) comprising a plurality of diodes (102) according to one of the previous claims, wherein each of the first electrodes (142) is furthermore electrically connected to the first semi-conductor portion (126) of at least one neighbouring diode (102) only by a contact with the side walls (134) of the second part (132) of the first semi-conductor portion (126) of said at least one neighbouring diode (102).

11. Electronic device (100) according to claim 10, wherein the diodes (102) belong to an array of diodes (102) of similar structures forming a pixel array of the electronic device (100).

12. Method for producing a light-emitting or light-receiving diode (102), comprising at least the steps of:
- producing a stack of layers comprising at least first and second doped semi-conductor layers (106, 114) according to opposite types of conductivity and at least one electrically conducting and optically reflecting layer (115), such that the second semi-conductor layer (114) is arranged between the first semi-conductor layer (106) and the electrically conducting and optically reflecting layer (115);
- performing a first etching of the stack of layers through the electrically conducting layer (115), the second semi-conductor layer (114) and a part of the thickness of the first semi-conductor layer (106), forming a first part (119) of a second electrode (144) of the diode (102), a second semi-conductor portion (120) having a face entirely covered by the first part (119) of the second electrode (144), and a first part (124) of a first semi-conductor portion (126) through which a light is intended to be emitted or received by the diode (102);
- producing dielectric portions (130) covering side walls of the first part (119) of the second electrode (144), the second semi-conductor portion (120) and the first part (124) of the first semi-conductor portion (126);
- performing a second etching of the stack of layers through a remaining thickness of the first semi-conductor layer (106), forming a second part (132) of the first semi-conductor portion (126) such that the first part (124) of the first semi-conductor portion (126) is arranged between the second part (132) of the first semi-conductor portion (126) and the first part (119) of the second electrode (144), the first and second semi-conductor portions (120, 126) forming a p-n junction;
- producing a first electrode (142) arranged against outer side walls of the dielectric portions (130) and against side walls (134) of the second part (132) of the first semi-conductor portion (126), the first electrode (142) being electrically connected to the first semi-conductor portion (126) only by a contact with the side walls (134) of the second part (132) of the first semi-conductor portion (126) and passing through the entire thickness of the first semi-conductor portion (126), and producing a second part of the second electrode (144) on the first part (119) of the second electrode (144).

13. Method according to claim 12, wherein the first etching of the stack of layers is implemented through a dielectric mask (118) arranged on the stack of layers, and wherein the dielectric portions (130) cover side walls of the dielectric mask (118).

14. Method according to claim 13, wherein the second etching of the stack takes place such that the outer side walls of the dielectric portions (130) are aligned with the side walls (134) of the second part (132) of the first semi-conductor portion (126).

15. Method according to either claim 13 or claim 14, wherein the production of the first electrode (142) and of the second part of the second electrode (144) comprises the implementation of the steps of:
- producing an opening (136) through the dielectric mask (118) and opening out onto the first part (119) of the second electrode (144);
- depositing at least one electrically conducting material (138, 140) into the opening (136) and in a space (128) formed through the stack of layers by the implementation of first and second etchings;
- planarising the electrically conducting material (138, 140) with a stop on the dielectric mask (118).

16. Method according to one of claims 12 to 15, wherein the stack of layers is produced on an initial substrate (104) such that the first semi-conductor layer (106) is arranged between the second semi-conductor layer (114) and the initial substrate (104).

17. Method according to claim 16, further comprising, after producing the first electrode (142) and the second part of the second electrode (144), a step of transferring the diode (102) onto an interconnect substrate (148) such that the first and second electrodes (142, 144) of the diode (102) are electrically connected to the interconnect substrate (148), then a step of removing the initial substrate (104).

18. Method for producing an electronic device (100) comprising the implementation of a method according to one of claims 12 to 17, wherein the implementation steps form a plurality of diodes (102) such that each of the first electrodes (142) is electrically connected to the first semi-conductor portion (126) of at least one neighbouring diode (102) only by a contact with the side walls (134) of the second part (132) of the first semi-conductor portion (126) of said at least one neighbouring diode (102).
